# EUROPEAN PATENT APPLICATION

(11) **EP 3 703 124 A1**
(43) Date of publication of application: **02.09.2020**
(21) Application number: 17936410.4
(22) Date of filing: 29.12.2017
(51) Int. Cl.: H01L 23/522, H01G 4/10

(54) **CAPACITOR**

(71) Applicant: Huawei Technologies Co. Ltd., Guangdong 518129 (CN)
(72) Inventor: WANG, Shengrong, Shenzhen, Guangdong 518129 (CN); XU, Xiangming, Shenzhen, Guangdong 518129 (CN)
(74) Representative: Pfenning, Meinig & Partner mbB
(86) International application number: PCT/CN2017/120203
(87) International publication number: WO 2019/127489

(57) **Abstract**

A capacitor includes a first terminal, a second terminal, a first capacitor, and a second capacitor. The first capacitor includes at least two first conductors arranged in a first direction, where each two adjacent first conductors in the at least two first conductors are separated by a first dielectric, a part of the at least two first conductors is electrically coupled to the first terminal, and the other part of the at least two first conductors is electrically coupled to the second terminal. The second capacitor includes at least two second conductors arranged in a second direction, where each two adjacent second conductors in the at least two second conductors are separated by a second dielectric, a part of the at least two second conductors is electrically coupled to the first terminal, and the other part of the at least two second conductors is electrically coupled to the second terminal. The first capacitor and the second capacitor each have an interdigital structure.

## Description

### TECHNICAL FIELD

This application relates to the field of electronic technologies, and in particular, to a capacitor.

### BACKGROUND

With evolution of integrated circuit manufacturing processes, various devices are continuously reduced in a manufacturing process size. A metal-oxide-metal (MOM, Metal-Oxide-Metal) capacitor is widely used for its comparatively small area. In comparison with a metal-insulator-metal (MIM, Metal-Insulator-Metal) capacitor, by using the MOM capacitor, not only an area is reduced, but also no additional mask (mask) is required, thereby reducing manufacturing costs. The MOM capacitor includes a plurality of plates and a dielectric located between the plates. The plate may be located at a metal layer, and the dielectric may be located at a dielectric layer between different metal layers. With evolution of technologies, the metal layer or the dielectric layer, of the MOM capacitor manufactured by using an advanced manufacturing process, has an increasingly reduced thickness, and therefore it becomes increasingly difficult to accurately control thicknesses of all layers in the manufacturing process. Consequently, this causes an increasingly large process corner (process corner) of the MOM capacitor, and causes a process fluctuation or a deviation. The process fluctuation or the deviation is also referred to as manufacturing process non-ideality. In a prior-art MOM capacitor structure, the MOM capacitor is arranged in a horizontal direction or a vertical direction. Once a deviation occurs in a dielectric thickness of the MOM capacitor due to manufacturing process non-ideality, a capacitance value is inaccurate, for example, the capacitance value is greater than or less than a preset capacitance value, affecting system performance. Therefore, how to reduce a deviation of a capacitance value caused by a manufacturing process fluctuation becomes a difficult problem.

### SUMMARY

Embodiments of this application provide a capacitor, to reduce a deviation of a capacitance value caused by a manufacturing process fluctuation.

In view of this, a first aspect of this application provides a capacitor, including a first terminal, a second terminal, a first capacitor, and a second capacitor. The first capacitor includes at least two first conductors and a first dielectric, where the at least two first conductors are arranged in a first direction, each two adjacent first conductors in the at least two first conductors are separated by the first dielectric, a part of the at least two first conductors is electrically coupled to the first terminal, and the other part of the at least two first conductors is electrically coupled to the second terminal. The second capacitor includes at least two second conductors and a second dielectric, where the at least two second conductors are arranged in a second direction that is different from the first direction, each two adjacent second conductors in the at least two second conductors are separated by the second dielectric, a part of the at least two second conductors is electrically coupled to the first terminal, and the other part of the at least two second conductors is electrically coupled to the second terminal.

According to the foregoing technical solution, once manufacturing process non-ideality causes a change of a process parameter in a direction, for example, a thickness of the first dielectric, a capacitance value of the first capacitor arranged in the direction changes in a specific trend. Because the first capacitor and the second capacitor are arranged in different directions, lengths of the at least two second conductors of the second capacitor arranged in the other direction change accordingly with a thickness change of the first dielectric. Consequently, a capacitance value of the second capacitor and the capacitance value of the first capacitor have different change trends. This helps reduce a deviation of a capacitance value of an entire capacitor caused by manufacturing process non-ideality.

In a possible implementation, each two adjacent first conductors include a third conductor and a fourth conductor, where the third conductor is electrically coupled to the first terminal, and the fourth conductor is electrically coupled to the second terminal. In this solution, a plurality of first conductors electrically coupled to the first terminal and a plurality of first conductors electrically coupled to the second terminal may form a first interdigital structure, thereby optimizing a volume of the first capacitor.

In another possible implementation, each two adjacent second conductors include a fifth conductor and a sixth conductor, where the fifth conductor is electrically coupled to the first terminal, and the sixth conductor is electrically coupled to the second terminal. In this solution, a plurality of second conductors electrically coupled to the first terminal and a plurality of second conductors electrically coupled to the second terminal may form a second interdigital structure, thereby optimizing a volume of the second capacitor.

In another possible implementation, the at least two first conductors are respectively located at at least two conducting layers of a plurality of layers, where the plurality of layers are arranged in the first direction. Optionally, the first direction may be a vertical direction. In this case, the first capacitor is a vertical capacitor, for example, the first capacitor may include a metal plate capacitor.

Further, in another possible implementation, the first dielectric is located at at least one dielectric layer in the plurality of layers. Optionally, the second capacitor penetrates the at least two conducting layers and the at least one dielectric layer.

In another possible implementation solution, the at least two second conductors penetrate at least part of the plurality of layers. Optionally, the at least two second conductors penetrate the at least part of the plurality of layers by using at least one via (VIA) or at least one slot via (Slot VIA). The second capacitor penetrates all or part of the plurality of layers to form a horizontal capacitor. For example, the horizontal capacitor may include a capacitor formed between horizontal metals, and may further optionally include a capacitor formed between horizontal vias or a capacitor formed between horizontal slot vias. Further, in a possible example, the at least one via or the at least one slot via is located at and penetrates the at least one dielectric layer in the at least part of the plurality of layers.

In another possible implementation, the second direction is substantially perpendicular to the first direction. For example, the substantial perpendicularity means that an included angle between the second direction and the first direction is close to 90 degrees, or that a difference between 90 degrees and a value of the included angle between the second direction and the first direction is less than a preset threshold.

In another possible implementation, at least a part of the at least two first conductors is combined with at least a part of the at least two second conductors. In this solution, at least a part of the first capacitor is combined with at least a part of the second capacitor. That is, there is a merged part between the first capacitor and the second capacitor. Such a design helps reduce a volume of the capacitor.

In another possible implementation, the at least two first conductors are independent of the at least two second conductors, that is, there is no merged part. Further, the first capacitor and the second capacitor may be separated by a third-party device. In other words one or more other devices may be included between the first capacitor and the second capacitor. Even if the two capacitors are not directly adjacent to each other, but are spaced by another device, the implementation of this technical solution is not affected.

In another possible implementation, at least one of the at least two first conductors and the at least two second conductors includes at least one of the following materials: a metal material or a semiconductor material. For example, when the first direction is the vertical direction, the semiconductor material is used for a first conductor, at a bottom layer, of the at least two first conductors, and the metal material is used for the other first conductor. The first capacitor implemented by using such a design is comparatively easy in implementation by using a process.

In another possible implementation, a same material, for example, the metal material, is used for the at least two first conductors and the at least two second conductors.

In another possible implementation, a same dielectric material, for example, silicon dioxide is used for the first dielectric and the second dielectric.

In another possible implementation, the capacitor is integrated on a semiconductor chip. When the foregoing technical solutions are applied to an integrated circuit such as the semiconductor chip, a good effect can be achieved, and the deviation of the capacitance value of the capacitor caused by semiconductor manufacturing process non-ideality can be better reduced. Further, the semiconductor chip may include a radio frequency chip. When the foregoing technical solutions are applied to the field of radio frequency, a better effect can be achieved than that in the field of low frequency signal processing.

In another possible implementation, at least one of the first capacitor and the second capacitor includes a metal-oxide-metal MOM capacitor. Alternatively, at least one of the first capacitor and the second capacitor may include a MIM capacitor. Alternatively, at least one of the first capacitor and the second capacitor may include a MOM capacitor and a metal-oxide-semiconductor (MOS, Metal-Oxide-Semiconductor) capacitor. Alternatively, at least one of the first capacitor and the second capacitor may include a MIM capacitor and a MOS capacitor.

A second aspect of this application provides a chip, including the capacitor mentioned in any one of the first aspect or the possible implementations of the first aspect. Optionally, the chip is a radio frequency chip.

A third aspect of this application provides a circuit board, including the capacitor mentioned in any one of the first aspect or the possible implementations of the first aspect.

The foregoing aspects or the possible implementations of this application are clearer and more comprehensible in descriptions of the following embodiments.

### BRIEF DESCRIPTION OF DRAWINGS

FIG. 1 is a schematic diagram of a capacitor disposed inside a semiconductor chip according to an embodiment of this application;
FIG. 2 is a schematic diagram of a three-dimensional structure of a capacitor according to an embodiment of this application;
FIG. 3 is a schematic diagram of a three-dimensional structure of another capacitor according to an embodiment of this application;
FIG. 4 is a two-dimensional top view of a via and a slot via that are used to form a capacitor according to an embodiment of this application;
FIG. 5 is a schematic diagram of a three-dimensional structure of another capacitor according to an embodiment of this application;
FIG. 6 is a schematic diagram of a three-dimensional structure of another capacitor according to an embodiment of this application;
FIG. 7 is a schematic diagram of a three-dimensional structure of another capacitor according to an embodiment of this application;
FIG. 8 is a schematic diagram of a three-dimensional structure of another capacitor according to an embodiment of this application;
FIG. 9 is a schematic diagram of a three-dimensional structure of another capacitor according to an embodiment of this application;
FIG. 10 is a schematic diagram of a three-dimensional structure of another capacitor according to an embodiment of this application;
FIG. 11 is a schematic diagram of a three-dimensional structure of another capacitor according to an embodiment of this application;
FIG. 12 is a two-dimensional top view of a capacitor according to an embodiment of this application;
FIG. 13 is a two-dimensional top view of another capacitor according to an embodiment of this application;
FIG. 14 is a two-dimensional side view of a capacitor according to an embodiment of this application;
FIG. 15 is a two-dimensional side view of another capacitor according to an embodiment of this application;
FIG. 16 is a two-dimensional side view of capacitors arranged in a vertical direction according to an embodiment of this application; and
FIG. 17 is a two-dimensional side view of capacitors distributed at different layers according to an embodiment of this application.

### DESCRIPTION OF EMBODIMENTS

To make the technical solutions in the embodiments of this application more comprehensible, the following clearly describes the technical solutions in the embodiments of this application with reference to the accompanying drawings in the embodiments of this application. It is clearly that the described embodiments are merely some but not all of the embodiments of this application. In the embodiments of the specification, claims, and the foregoing accompanying drawings that are of this application, the terms "first", "second", "third", and the like are intended to distinguish between similar objects but do not necessarily indicate a specific order or sequence. In addition, the term "include" and any variation thereof are intended to cover non-exclusive inclusion, for example, a series of modules or units are included. The electrical coupling described in the embodiments includes any form of electrical connection such as a direct contact, and an electrical connection is implemented by using a conducting wire, a via, a slot via, or another device.

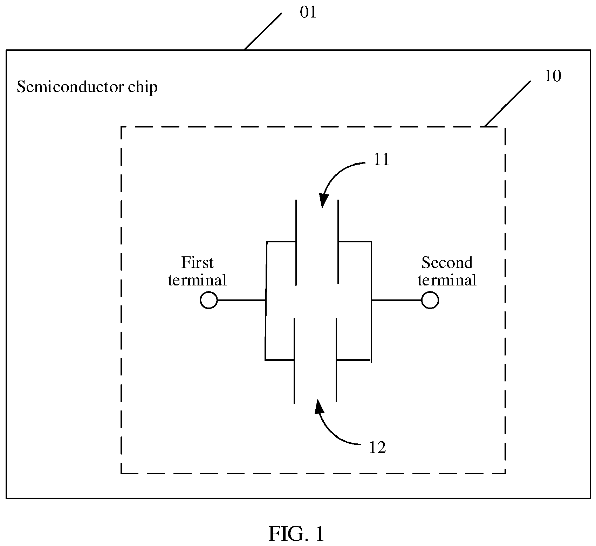

In a modern communications or electronic system, a capacitor is increasingly widely applied. For example, the capacitor is applied to a semiconductor chip or another type of circuit such as a printed circuit board (PCB, Printed Circuit Board). FIG. 1 is a schematic diagram of a capacitor 10 disposed inside a semiconductor chip 01 according to an embodiment of this application. The semiconductor chip 01 may also be referred to as a chip, and the semiconductor chip 01 may be a set of integrated circuits that are formed on a substrate of an integrated circuit by using an integrated circuit process. The substrate is usually a semiconductor material such as silicon. An exterior of the substrate on which the integrated circuit is formed is usually packaged by using a semiconductor packaging material. The integrated circuit may include various types of functional devices, and each type of functional device includes a transistor such as a logic gate circuit, a MOS transistor, a bipolar transistor, or a diode, or the integrated circuit may include another device such as a capacitor, a resistor, or an inductor. The functional device may operate independently or operate under driving of necessary drive software, and may implement various functions such as communication, operation, and storage. For example, the semiconductor chip 01 may include an application processor chip, a video processor chip, a communications chip, a control chip, an artificial intelligence chip, a radio frequency chip, or a system on chip (SoC, System on Chip) that integrates any plurality of functions of the foregoing chips. This is not limited in the embodiments.

In FIG. 1, the semiconductor chip 01 includes a capacitor 10, where the capacitor 10 includes a first capacitor 12 and a second capacitor 11. One terminal of the first capacitor 12 is electrically coupled to one terminal of the second capacitor 11 and is electrically coupled to a first terminal of the capacitor 10. The other terminal of the first capacitor 12 is electrically coupled to the other terminal of the second capacitor 11 and is electrically coupled to a second terminal of the capacitor 10. The capacitor 11 and the capacitor 12 are arranged in different directions in a three-dimensional structure. For example, one capacitor is arranged in one direction such as a vertical direction, and the other capacitor is arranged in the other direction such as a horizontal direction. Such a design can reduce a deviation of a capacitance value of the capacitor 10 caused by semiconductor manufacturing process non-ideality. For example, a change occurs in a dielectric thickness of the capacitor arranged in the vertical direction, and this change usually accordingly causes a change of a length or an area of a plate of the other capacitor arranged in the horizontal direction. In this way, capacitance values of the two capacitors have different change trends, so as to reduce impact made by manufacturing process non-ideality. This is described in more detail in subsequent embodiments.

This embodiment is described by using an example that the capacitor 10 is disposed inside the semiconductor chip 01. It may be understood that the capacitor 10 may be disposed in a device manufactured by using another manufacturing process, for example, the capacitor 10 is disposed inside a PCB or another discrete device. Provided that the capacitor can be used to overcome a deviation of a capacitance value caused by a specific manufacturing process fluctuation, the capacitor in this embodiment can be applied to a product manufactured by using the specific manufacturing process.

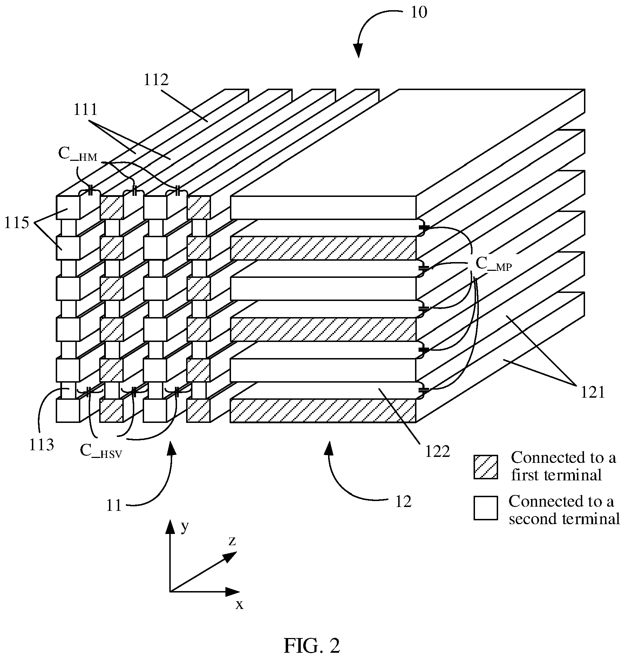

To better understand the structure of the capacitor 10, FIG. 2 provides a schematic diagram of a three-dimensional structure of the capacitor 10 according to an embodiment of this application. In the three-dimensional schematic diagram, there are three coordinate axes: x, y, and z, where the x-axis represents a length direction or a horizontal direction, the z-axis represents a width direction or a depth direction, and the y-axis represents a height direction or a vertical direction. The z-axis and the x-axis are used to form a horizontal plane, and the y-axis is perpendicular to the horizontal plane. In the three-dimensional structure, the capacitor 10 is a MOM capacitor, and the capacitor 10 includes the first capacitor 12 arranged in the vertical direction on a right side and the second capacitor 11 arranged in the horizontal direction on a left side. The first capacitor 12 includes a plurality of first conductors 121 arranged in the vertical direction. Each two adjacent first conductors 121 are separated by a first dielectric 122, to form a plurality of vertical capacitors arranged in the vertical direction. For example, the plurality of vertical capacitors specifically include a plurality of metal plate capacitors (metal plate capacitor) C_{_MP}. The first capacitor 12 includes the plurality of vertical capacitors. The second capacitor 11 includes a plurality of second conductors 111 arranged in the horizontal direction. Each two adjacent second conductors 111 are separated by a second dielectric 112, to form a plurality of horizontal capacitors arranged in the horizontal direction. For example, the plurality of horizontal capacitors specifically include a plurality of capacitors formed between horizontal metals (capacitor formed between horizontal metal) C_{_HM} and a plurality of capacitors formed between horizontal slot vias (capacitor formed between horizontal slot VIA) C_{_HSV}. The second capacitor 11 includes the plurality of horizontal capacitors.

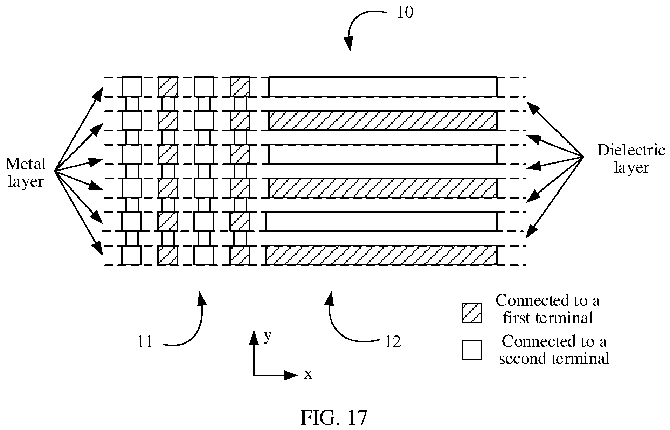

In the first capacitor 12 of FIG. 2, each first conductor 121 is a plate of one vertical capacitor, and is located at one conducting layer. A metal layer is a typical conducting layer. For example, any first conductor 121 may be a metal plate, and is located at one metal layer of a plurality of layers in the semiconductor chip 01. The first dielectric 122 located between any two adjacent first conductors 121 or located between metal layers is located at one dielectric layer. For details, refer to a two-dimensional side view of FIG. 17. A plurality of first conductors 121 electrically coupled to the first terminal and a plurality of first conductors 121 electrically coupled to the second terminal may form an interdigital structure. In other words, two first conductors 121 included in any metal plate capacitor C_{_MP} are respectively electrically coupled to the first terminal and the second terminal, and the plurality of metal plate capacitors C_{_MP} are configured to form the first capacitor 12.

In the second capacitor 11 of FIG. 2, each second conductor 111 penetrates at least part of the plurality of layers in the semiconductor chip 01 by using one or more slot vias 113. For example, in the vertical direction, each second conductor 111 includes a plurality of corresponding slot vias 113 and a plurality of metal conductors 115 located at a plurality of metal layers. Each second conductor 111 forms one plate of the second capacitor 11. A conductive material such as metal may be used for the slot via 113, to be electrically connected to different metal conductors 115 at different conducting layers. The slot via 113 may be manufactured by using a conventional via-slot manufacturing method in a semiconductor manufacturing process. In the horizontal direction, each metal conductor 115 is located at a same metal layer as one metal plate of a corresponding first conductor 121, and this is specifically shown in FIG. 2. Any slot via 113 may be located at and penetrate one dielectric layer. Specifically, any slot via 113 may be located at a same dielectric layer as a corresponding first dielectric 122. For details, also refer to the two-dimensional side view of FIG. 17. The metal plate 121 or the metal conductor 115 may include various metals such as aluminum, copper, or tin. Various insulating materials such as silicon dioxide may be used for the dielectric or the dielectric layer, to implement a dielectric function of the capacitor.

In FIG. 2, for the second conductors 111, a capacitor formed between horizontal metals C_{_HM} is formed by using two adjacent metal conductors 115 located at one metal layer and the second dielectric 112 between the adjacent metal conductors 115, and a capacitor formed between horizontal slot vias C_{_HSV} is formed by using adjacent slot vias 113 located at one dielectric layer and the second dielectric 112 between the adjacent slot vias 113. The second capacitor 11 includes the plurality of horizontal capacitors, and each horizontal capacitor includes the plurality of capacitors formed between horizontal metals C_{_HM} and the plurality of capacitors formed between horizontal slot vias C_{_HSV}. One second conductor 111 served as a plate of each horizontal capacitor is electrically coupled to the first terminal, and the other second conductor 111 served as another plate is electrically coupled to the second terminal.

In FIG. 2, a conductor electrically coupled to the first terminal is shown shaded, and a conductor electrically coupled to the second terminal is shown colorless. It can be seen that, in both the first capacitor 12 and the second capacitor 11, the conductor electrically coupled to the first terminal and the conductor electrically coupled to the second terminal are staggered arranged. In other words, two adjacent conductors are not electrically coupled to one terminal of the capacitor 10, and such a cross arrangement design is the interdigital structure. For details, refer to FIG. 17. FIG. 17 is a two-dimensional side view of a simplified structure of FIG. 2. FIG. 17 includes the plurality of layers of the semiconductor chip 01, and specifically includes the plurality of metal layers and a dielectric layer that is located between adjacent metal layers. The plurality of first conductors 121 at different metal layers form the first capacitor 12, and the plurality of second conductors 111 that penetrate the plurality of layers form the first capacitor 11.

According to the foregoing technical solutions, even if manufacturing process non-ideality causes a deviation of a process parameter in a direction, for example, a thickness of one dielectric layer or thicknesses of a plurality of dielectric layers, a capacitance value of the vertical capacitor changes in a specific trend, and a capacitance value of the horizontal capacitor that changes in the same trend as that of the vertical capacitor is reduced, thereby helping reduce the deviation of the capacitance value of the entire capacitor 10 caused by semiconductor manufacturing process non-ideality. For example, when the thickness of one dielectric layer increases or the thicknesses of the plurality of dielectric layers increase, a dielectric thickness of the vertical capacitor increases, so that the capacitance value decreases. However, such an increase in the thickness results in an increase of a capacitance value of the capacitor formed between horizontal slot vias, and further results in an increase of the capacitance value of the horizontal capacitor. It is equivalent to that a length or an area of the plate of the horizontal capacitor increases. Such an effect reduces, to some extent, impact made by a decrease in the capacitance value of the vertical capacitor, thereby helping reduce the deviation of the capacitance value of the entire capacitor 10, and reducing impact made by a process corner. Further, in consideration of the effect for reducing the deviation caused by the manufacturing process in this embodiment, design flexibility of a gap between different metal layers in the interdigital structure is improved, that is, design flexibility of the thickness of the dielectric layer is also improved. Specifically, the thickness of the dielectric layer may be designed to be a very small value, thereby helping reduce a volume of the capacitor 10.

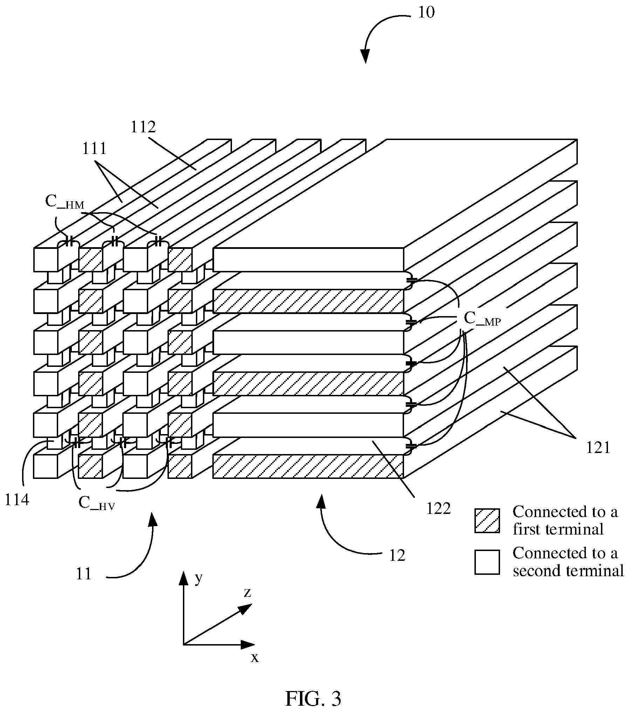

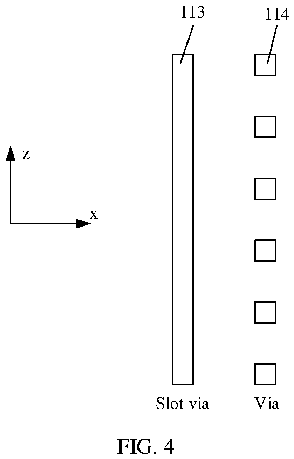

FIG. 3 is a schematic diagram of a three-dimensional structure of another capacitor 10 according to an embodiment of this application. A difference from FIG. 2 is that the slot via 113 used to penetrate the plurality of layers in the semiconductor chip 01 may be replaced with a via 114. In this case, in FIG. 3, the capacitor formed between horizontal slot vias C_{_HSV} is replaced with a capacitor formed between horizontal vias C_{_HV}. For ease of understanding, referring to FIG. 4, a two-dimensional top view of a via and a slot via that are used to form the capacitor is provided. An x-axis still represents a horizontal direction, and a z-axis still represents a depth direction. The slot via 113 on a left side is a complete slot in the depth direction. A plurality of vias 114 on a right side independently exist in the depth direction. In other words, the plurality of vias 114 are not connected to form a complete part in the depth direction. However, an implementation effect of the plurality of vias 114 is similar to that of the slot via 114 as a complete part.

In the embodiments of the present invention, the slot via 113 or the via 114 may be configured to be electrically connected to different metal conductors 115 at different conducting layers, and the slot via 113 or the via 114 is configured to form the capacitor formed between horizontal slot vias C_{_HSV} or the capacitor formed between horizontal vias C_{_HV}. A metal material may be optionally used for either of the slot via 113 or the via 114 to implement electrical connectivity. In an alternative embodiment, the slot via 113 or the via 114 may be replaced with another connection portion that can penetrate the dielectric layer and that is configured to be electrically connected to different metal conductors 115 at different conducting layers. Beneficial effects similar to those in the foregoing embodiments can be achieved, provided that the connection portion can form a capacitor arranged in the horizontal direction that is to be distinguished from a plurality of vertical capacitors arranged in the vertical direction. For example, when a dielectric thickness of the vertical capacitor increases, a capacitance value of the vertical capacitor decreases. In this case, a length of a plate a horizontal capacitor usually increases accordingly with the increase of the thickness. That is, an area of the plate of the horizontal capacitor is increased, thereby helping increase a capacitance value of the horizontal capacitor. Capacitance values of different capacitors changing in different trends can help offset adverse effects caused by manufacturing process non-ideality.

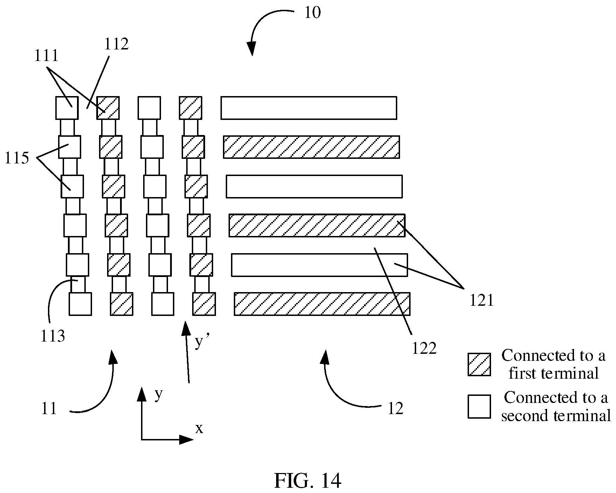

In the foregoing embodiments, the three-dimensional coordinate axes x, y, and z are perpendicular to each other, and the first direction (vertical) in which the first capacitor 12 is arranged and the second direction (horizontal) in which the second capacitor 1 is arranged are perpendicular to each other. Generally, it may be understood that the second direction may not be strictly perpendicular to the first direction in actual engineering implementation. That is, there is an angular deviation. Beneficial effects of this embodiment can be effectively achieved provided that the second direction is substantially perpendicular to the first direction. For example, the substantial perpendicularity means that an included angle between the second direction and the first direction is close to 90 degrees, or that a difference between 90 degrees and a value of the included angle between the second direction and the first direction is less than a preset threshold. How to set the threshold or how to make the included angle approach 90 degrees through configuration may be implemented through calculation based on historical empirical values, experimental data, or theories according to different manufacturing processes. This is not specifically limited in this embodiment. Specifically, referring to FIG. 14, it can be seen from a two-dimensional side view of FIG. 14 that a plurality of adjacent second conductors 111 are not strictly arranged in the x-axis horizontal direction. That is, none of the second conductors 111 is a strict vertical structure extending along the y-axis direction. An extension direction y' of the second conductor 111 is not perpendicular to the x-axis, and therefore a formed horizontal capacitor strictly is not a horizontal capacitor. However, based on the description in the foregoing embodiment, impact made by a manufacturing process fluctuation can still be suppressed to some extent, thereby implementing a more accurate capacitance value.

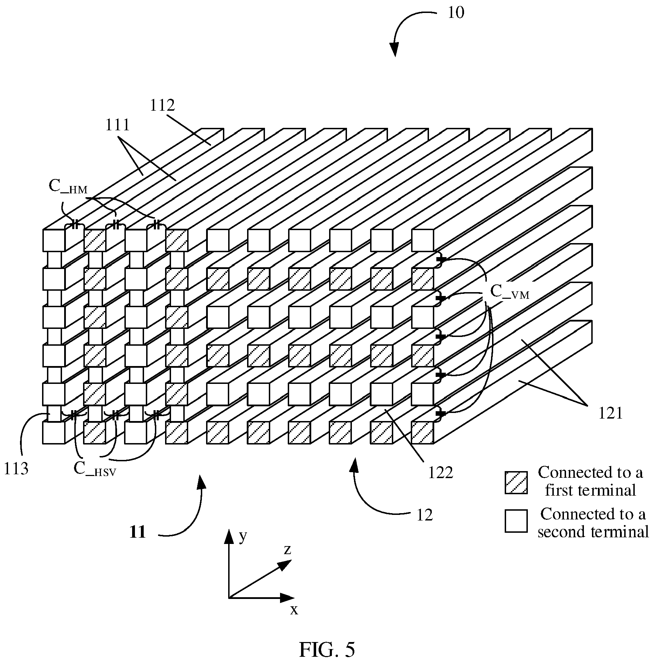

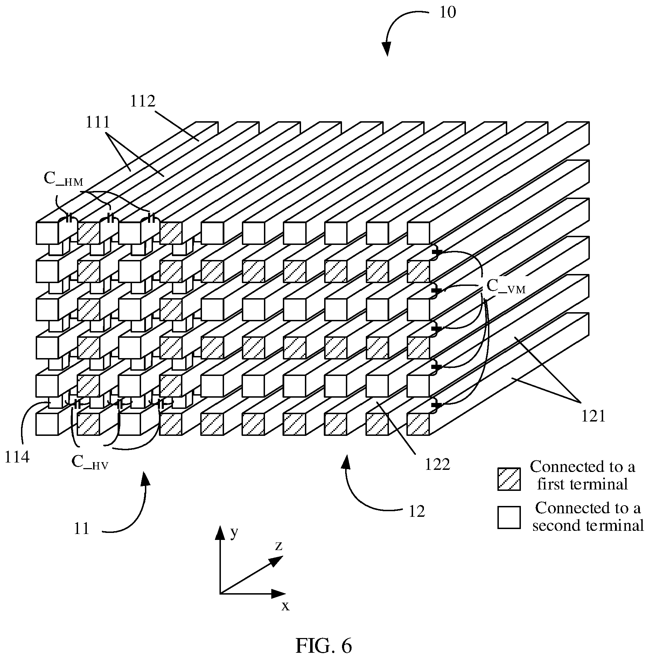

FIG. 5 is a schematic diagram of a three-dimensional structure of another capacitor 10 according to an embodiment of this application. A difference from FIG. 2 is that in FIG. 5, first conductors 121 used to form a metal plate capacitor C_{_MP} at any one or more metal layers are not a complete metal conductor, but a plurality of metal conductors separated from each other. For example, at one metal layer, the first conductors 121 include a plurality of discontinuous metal conductors along an x-axis, that is, along an extension direction in a horizontal direction. FIG. 6 is a schematic diagram of a three-dimensional structure of another capacitor 10 according to an embodiment of this application. A difference from FIG. 5 is that the slot via 113 is replaced with a via 114, but other designs are similar.

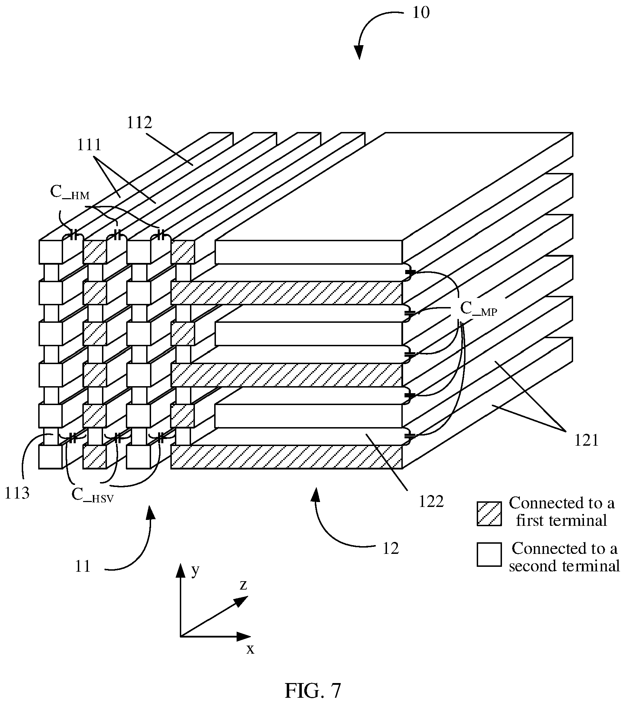

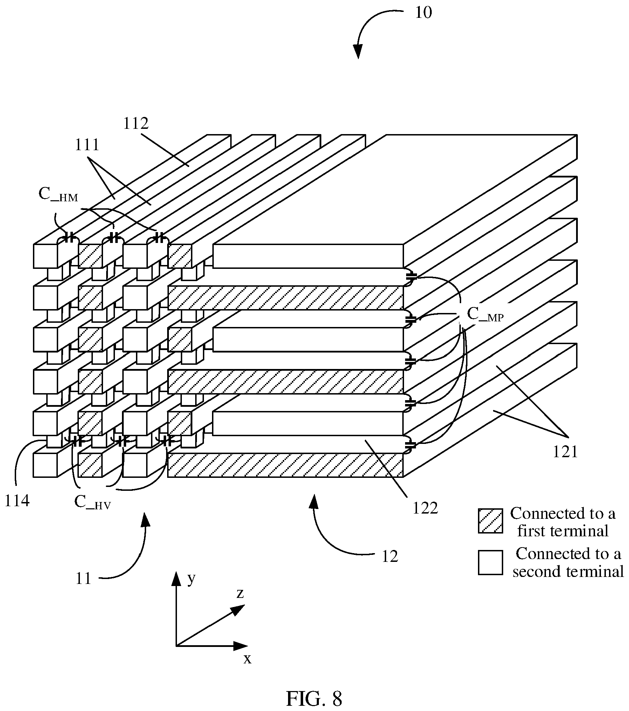

FIG. 7 is a schematic diagram of a three-dimensional structure of another capacitor 10 according to an embodiment of this application. A difference from FIG. 2 is that, in FIG. 7, at least a part of first conductors 121 of a first capacitor 12 is combined with at least a part of second conductors 111 of a second capacitor 11. For example, in a part close to the first capacitor 12 and the second capacitor 11, a plurality of first conductors 121 electrically coupled to a first terminal are coupled to a part of one second conductor 111 electrically coupled to the first terminal, to form a merged part. However, this does not affect a technical effect achieved in this embodiment. FIG. 8 is another variant embodiment. A difference between FIG. 8 and FIG. 7 is that the slot via 113 is replaced with a via 114. In the solution with the merged part, a boundary between the first capacitor 12 and the second capacitor 11 is no longer distinct. Although functionally, the first capacitor 12 and the second capacitor 11 are arranged in different directions and the first capacitor 12 and a deviation of a capacitance value of the entire capacitor 10 caused by a manufacturing process fluctuation can be reduced, the first capacitor 12 and the second capacitor 11 are physically closely coupled.

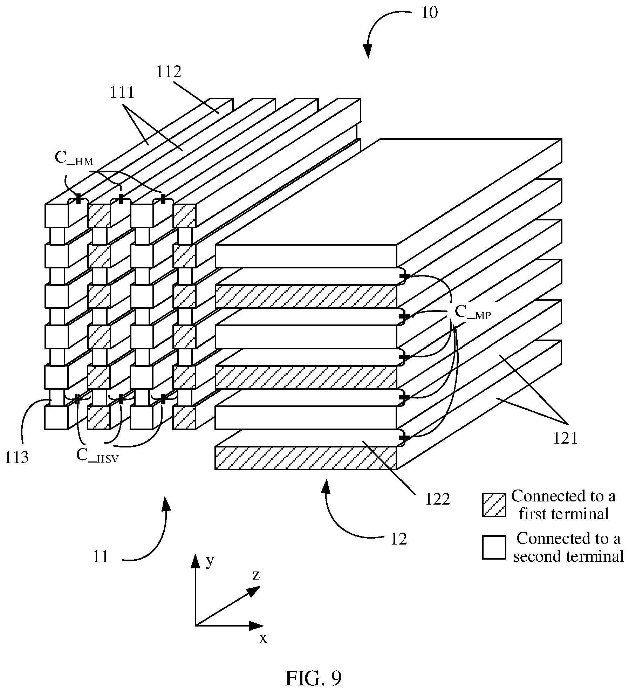

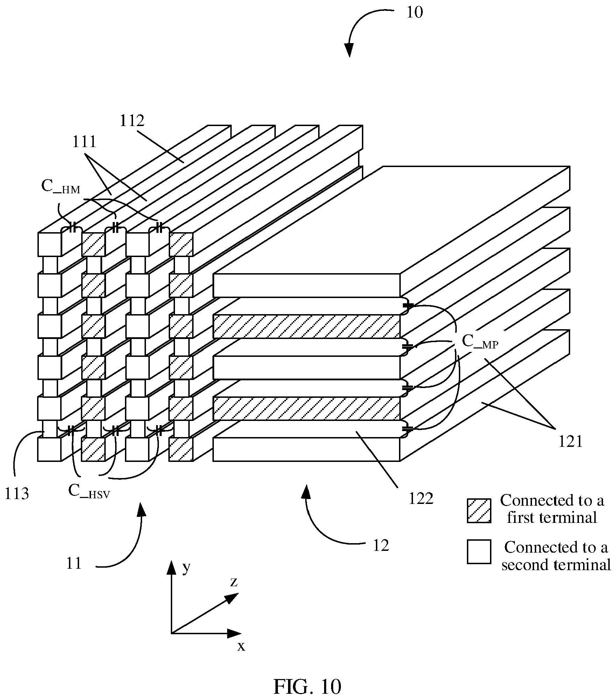

FIG. 9 is a schematic diagram of a three-dimensional structure of another capacitor 10 according to an embodiment of this application. A difference from FIG. 2 is that there is no corresponding second conductors 111 on a left side of first conductors 121 that are at a bottom metal layer and that form a first capacitor 12. On the contrary, there is no corresponding first conductor 121 on a right side of second conductors 111 that are at a top metal layer. That is, a plurality of layers corresponding to the first capacitor 12 are not completely aligned with a plurality of layers corresponding to the second capacitor 11. FIG. 10 shows another embodiment. A difference from FIG. 9 is that a quantity of a plurality of layers that are configured to form a first capacitor 12 is less than a quantity of a plurality of layers that are configured to form a second capacitor 11. It can be learned from the embodiment corresponding to FIG. 9 or FIG. 10 that the plurality of layers at which the first capacitor 12 is located may be partially different from the plurality of layers that the second capacitor 11 penetrates. In an alternative implementation, the quantity of the plurality of layers at which the first capacitor 12 is located may be completely different from the quantity of the plurality of layers that the second capacitor 11 penetrates. This case is not shown in the accompanying drawings, but this does not affect implementation of this embodiment, and beneficial effects can still be achieved.

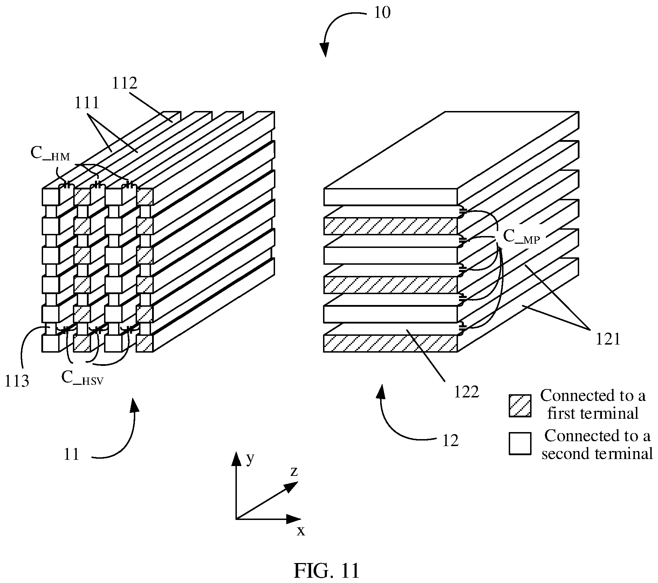

In the foregoing embodiments, the first capacitor 12 and the second capacitor 11 are adjacent to each other, but the first capacitor 12 and the second capacitor 11 may be farther away from each other in actual implementation, as shown in FIG. 11. For example, the first capacitor 12 and the second capacitor 11 may be separated by a third-party device that is not shown in FIG. 11. That is, a difference from FIG. 2 is that the two capacitors in FIG. 11 may not be directly adjacent to each other, and are spaced by another one or more devices. This does not affect the implementation of this technical solution. For example, the third-party device may be a radio frequency device.

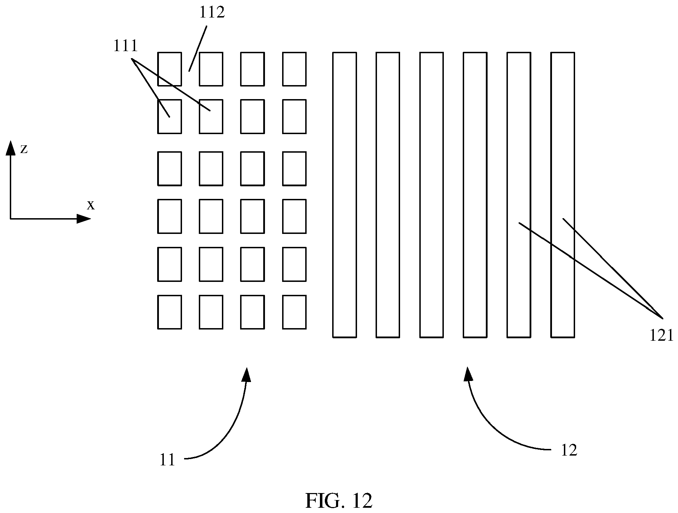

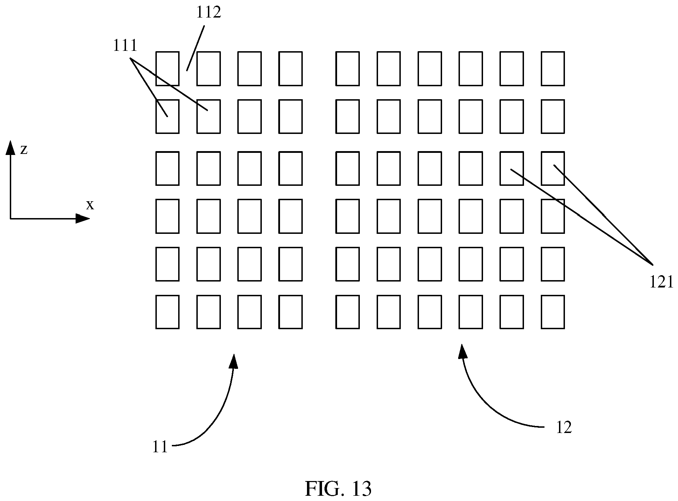

The capacitor 10 in this embodiment of this application may have another variant. For example, as shown in a two-dimensional top view of FIG. 12, in an alternative embodiment, along a z-axis depth direction, any one or more second conductors 111 may not be a complete conductor, but include a plurality of conductors separated from each other. That is, for any one or more metal conductors 115, in the z-axis depth direction, the metal conductors 115 may form a plurality of discontinuous metal conductors separated from each other. FIG. 13 shows another alternative embodiment. In FIG. 13, along a z-axis depth direction, any one or more first conductors 121 may not be a complete conductor, but include a plurality of discontinuous metal bodies separated from each other. Therefore, in this embodiment, a plurality of different forms of physical structures may be included, but achieved beneficial effects are similar to those in the foregoing embodiments.

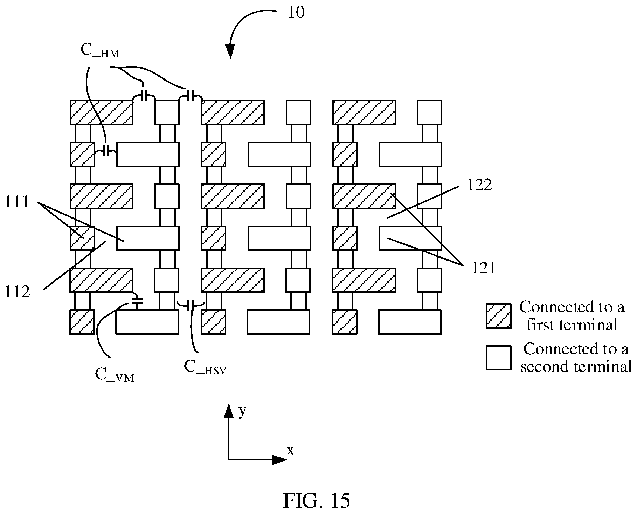

FIG. 15 is a two-dimensional side view of another capacitor 10 according to an embodiment of this application. A structure corresponding to FIG. 15 is a further variant based on the foregoing embodiments. In FIG. 15, a first conductor 121 is combined with a second conductor 111. For one metal conductor 115, the metal conductor 115 is configured to form the first conductors 121 in a first capacitor 12, and the metal conductor 115 is configured to form the second conductors 111 in a second capacitor 11. Therefore, it may be considered that the metal conductor 115 is configured to form the second conductors 111 in a horizontal direction, and that the metal conductor 115 is configured to form the first conductors 121 in a vertical direction. Therefore, such a design of combination achieves better merge between the first capacitor 12 and the second capacitor 11. Although the two capacitors are arranged in different directions, and existence of the two different capacitors is conducive to reducing adverse impact made by a manufacturing process fluctuation. However, the two capacitors physically form a complete part without an obvious physical boundary.

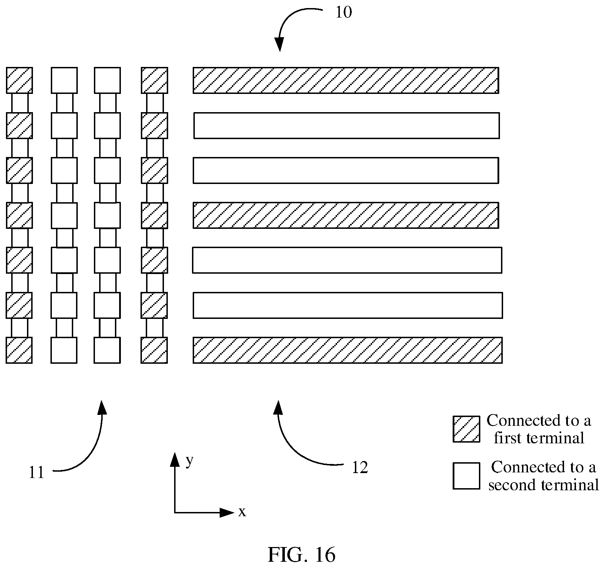

It should be noted that, in the foregoing embodiments, regardless of whether in the first capacitor 12 or the second capacitor 11, the conductor configured to connect to the first terminal and the conductor configured to connect to the second terminal may form the interdigital structure. Such an interdigital structure has comparatively high efficiency, and can implement a preset capacitance value by occupying only a comparatively small volume. In an alternative implementation, the interdigital structure may not be used for at least one of the first capacitor 12 and the second capacitor 11. Specifically, referring to FIG. 16, the interdigital structure is used for neither the first capacitor 12 nor the second capacitor 11. In other words, any two adjacent conductors are not necessarily respectively connected to different terminals of the first terminal and the second terminal. There may be case in which the two adjacent conductors may be connected to one terminal such as the second terminal. Such a case may be an effective extension of the foregoing embodiments, and impact made by a manufacturing process deviation can still be reduced in this case.

In another possible implementation, at least one of one or more first conductors 121 and one or more second conductors 111 includes at least one of the following materials: a metal material or a semiconductor material. In the foregoing embodiments, that the metal material is used for the conductor is used as an example for descriptions, but this is not intended for limitation. For example, in the vertical direction, the semiconductor material is used for a first conductor, at a bottom layer, of a plurality of first conductors 121, and the metal material is used for another first conductor 121. The first capacitor implemented by using such a design is comparatively easy in implementation by using a process. In other words, when a plurality of vertical capacitors are formed in the vertical direction, a substrate of the semiconductor 01, that is, a part of the semiconductor may be directly used as a lower plate, at a bottom layer, of the vertical capacitor, replacing the metal plate at the bottom layer in the embodiment in FIG. 2. At least one another plate, above the substrate, used to form the vertical capacitor is still a metal plate, where the metal material is used for the metal plate, and the metal plate is located between metal layers. Specifically, the plurality of metal layers may be directly formed on the substrate by using an integrated circuit manufacturing process, and the capacitor is formed by fully using the substrate itself.

One or more dielectric materials may be used for the first dielectric 122 and the second dielectric 112 in the foregoing embodiments. For example, a same dielectric material, for example, silicon dioxide, may be used for the first dielectric 122 and the second dielectric 112. Certainly, silicon dioxide may be replaced with another one or more dielectric materials. A conductivity of a dielectric material used for a dielectric is usually less than a conductivity of a conductor.

In the foregoing embodiments, the capacitor 10 is integrated into an integrated circuit such as the semiconductor chip 01. Such application can achieve a good effect, and the deviation of the capacitance value of the capacitor caused by semiconductor manufacturing process non-ideality can be better reduced. In particular, the solutions of the embodiments are well applicable to the field of radio frequency. For example, when the semiconductor chip 10 includes a radio frequency chip, a better effect can be achieved than that in the field of low frequency signal processing.

In the foregoing embodiments of this application, the MOM capacitor is used as an example for description. Optionally, at least one of the first capacitor 12 and the second capacitor 11 may include a MIM capacitor and a MOS capacitor, or may include any combination of the MIM capacitor, the MOS capacitor, and the MOM capacitor. This is not limited in the embodiments.

In conclusion, the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof. These modifications or replacements do not make the essence of the corresponding technical solutions fall outside the scope of the technical solutions of the embodiments of this application. For example, for some specific operations in an apparatus embodiment, refer to the foregoing method embodiments.

## Claims

1. A capacitor, comprising a first terminal, a second terminal, a first capacitor, and a second capacitor, wherein
the first capacitor comprises at least two first conductors and a first dielectric, wherein the at least two first conductors are arranged in a first direction, each two adjacent first conductors in the at least two first conductors are separated by the first dielectric, a part of the at least two first conductors is electrically coupled to the first terminal, and the other part of the at least two first conductors is electrically coupled to the second terminal; and
the second capacitor comprises at least two second conductors and a second dielectric, wherein the at least two second conductors are arranged in a second direction that is different from the first direction, each two adjacent second conductors in the at least two second conductors are separated by the second dielectric, a part of the at least two second conductors is electrically coupled to the first terminal, and the other part of the at least two second conductors is electrically coupled to the second terminal.

2. The capacitor according to claim 1, wherein each two adjacent first conductors comprise a third conductor and a fourth conductor, wherein the third conductor is electrically coupled to the first terminal, and the fourth conductor is electrically coupled to the second terminal.

3. The capacitor according to claim 1 or 2, wherein each two adjacent second conductors comprise a fifth conductor and a sixth conductor, wherein the fifth conductor is electrically coupled to the first terminal, and the sixth conductor is electrically coupled to the second terminal.

4. The capacitor according to any one of claims 1 to 3, wherein the at least two first conductors are respectively located at at least two conducting layers of a plurality of layers, wherein the plurality of layers are arranged in the first direction.

5. The capacitor according to claim 4, wherein the at least two second conductors penetrate at least part of the plurality of layers.

6. The capacitor according to claim 5, wherein the at least two second conductors penetrate the at least part of the plurality of layers by using at least one via or at least one slot via.

7. The capacitor according to claim 6, wherein the at least one via or the at least one slot via is located at and penetrates at least one dielectric layer in the at least part of the plurality of layers.

8. The capacitor according to any one of claims 1 to 7, wherein the second direction is substantially perpendicular to the first direction.

9. The capacitor according to any one of claims 1 to 8, wherein at least a part of the at least two first conductors is combined with at least a part of the at least two second conductors.

10. The capacitor according to any one of claims 1 to 9, wherein at least one of the at least two first conductors and the at least two second conductors includes at least one of the following materials: a metal material or a semiconductor material.

11. The capacitor according to any one of claims 1 to 10, wherein a same material is used for the at least two first conductors and the at least two second conductors.

12. The capacitor according to any one of claims 1 to 11, wherein a same dielectric material is used for the first dielectric and the second dielectric.

13. The capacitor according to any one of claims 1 to 12, wherein the capacitor is integrated on a semiconductor chip.

14. The capacitor according to any one of claims 1 to 13, wherein at least one of the first capacitor and the second capacitor comprises a metal-oxide-metal MOM capacitor.

15. The capacitor according to any one of claims 1 to 14, wherein the first capacitor and the second capacitor are separated by a third-party device.
